# EUROPÄISCHE PATENTSCHRIFT

(11) **EP 2 291 064 B1**
(45) Veröffentlichungstag und Bekanntmachung des Hinweises auf die Patenterteilung: **17.08.2016**
(21) Anmeldenummer: 10008710.5
(22) Anmeldetag: 20.08.2010
(51) Int. Cl.: H05K 7/20

(54) **Elektronische Einheit mit Kühlrippen**
Electronic unit with cooling fins
Unité électronique dotée de nervures de refroidissement

(30) Priorität: 25.08.2009 DE 102009038806
(43) Veröffentlichungstag der Anmeldung: 02.03.2011
(73) Patentinhaber: Leutwein, Gerhard, 74653 Künzelsau (DE)
(72) Erfinder: Leutwein, Gerhard, 74653 Künzelsau (DE)
(74) Vertreter: Samson & Partner Patentanwälte mbB

(56) Entgegenhaltungen:
- EP-A2- 0 356 991
- DE-A1-102007 057 472
- JP-A- H10 150 284

## Beschreibung

### Gebiet der Erfindung

Die Erfindung betrifft eine Einheit mit elektronischen Bauelementen, die im Betrieb Verlustwärme abgeben. Zum Abführen der Verlustwärme umfasst die Einheit mehrere Kühlrippen.

### Hintergrund der Erfindung

Bekanntermaßen erzeugen die meisten elektronischen Bauelemente im Betrieb eine nicht unerhebliche Verlustwärme, die sie an ihre Umgebung abgeben. Besonders große Wärmemengen erzeugen beispielsweise Leistungsbauelemente, etwa Leistungstransistoren, oder Drosseln.

Vor allem bei einer Anordnung einer Vielzahl von Bauelementen in einem dichten Gehäuse, das zum Beispiel als Schutz vor Umwelteinflüssen wie Feuchtigkeit und Schmutz für viele Anwendungen notwendig ist, ergibt sich durch die Verlustwärme unter Umständen eine hohe Temperatur im Umfeld der Schaltung, was viele Bauelemente und auch Verbindungsstellen einer Schaltung in ihrer Lebensdauer beeinträchtigen oder sogar zerstören kann.

Konventionell werden zur Vermeidung einer Überhitzung häufig Kühlkörper, beispielsweise Kühlrippen, zum Abtransport der Verlustwärme in elektronische Einheiten integriert. Beispielsweise ist hierbei eine Trägerstruktur vorgesehen, auf deren einer Seite sich eine in einem dichten Gehäuse angeordnete, Verlustwärme erzeugende Schaltung befindet, während auf der anderen Seite Kühlrippen angebracht sind. Die Trägerstruktur ist dabei so ausgebildet, dass sie Verlustwärme der Schaltung an die Kühlrippen überträgt, welche die Verlustwärme wiederum an die Umgebung abgeben.

Als Erweiterung einer solchen Lösung schlägt die EP 1 996 004 A1 vor, Bauelemente mit hoher Wärmeabgabe, insbesondere Wickelgüter, in einem abgetrennten Gehäuseteil anzuordnen. Insbesondere sieht diese Druckschrift für eine Wandlereinrichtung ein Gehäuse mit Vertiefungen vor, wobei die Wickelgüter in den Vertiefungen angeordnet und gegenüber dem Rest des Gehäuses thermisch abgedämmt werden. Zur Kühlung der Wickelgüter dienen Kühlrippen an der Außenseite der Gehäusevertiefungen. Auf Grund der getrennten Anordnung ergibt sich eine niedrigere Temperatur im Gehäuseinneren.

Nachteilig an dieser Lösung ist die hierfür notwendige Abwandlung des Gehäuses. Die Vertiefungen erschweren die Herstellung des Gehäuses und ergeben eine sperrige Form der fertigen Einheit.

Eine andere Lösung stellt die DE 10 2004 030 457 A1 bereit, nach der ein Gehäuse in zwei Kammern geteilt wird, wobei die erste der Kammern dicht ausgeführt ist und eine hohe Schutzart aufweist, die zweite hingegen mit Lüftungsschlitzen versehen ist. An einer Trennwand zwischen den Kammern sind die elektronischen Bauelemente angeordnet, und zwar so, dass sich solche elektronischen Bauelemente, die vor Umwelteinflüssen geschützt werden sollen, in der ersten Kammer befinden, andere Bauelemente - beispielsweise vergossene Komponenten, die selbst eine hohe Schutzart aufweisen - in der zweiten Kammer. Die in der ersten Kammer angeordneten Bauelemente sind über die Trennwand thermisch mit Kühlkörpern gekoppelt, die wiederum in die zweite Kammer hineinragen. Aus der zweiten Kammer kann die Verlustwärme durch die Lüftungsschlitze abgeführt werden. Auch diese Lösung senkt die Temperatur in der ersten Kammer durch die Auslagerung von Bauelementen, die große Mengen an Verlustwärme abgeben.

Jedoch ergeben sich auch bei dieser Lösung Nachteile. So geht die Anordnung eines Teils der Bauelemente in der zweiten Kammer zu Lasten des Platzes, auf dem thermisch mit den Bauelementen in der ersten Kammer gekoppelte Kühlrippen bereitgestellt werden können. Aus diesem Grund ist noch keine optimale Kühlung der Bauelemente in der ersten Kammer gewährleistet. Des Weiteren sind das Kühlsystem und die Bauelemente in der zweiten Kammer den durch die Lüftungsschlitze wirkenden Umwelteinflüssen ausgesetzt.

### Zusammenfassung der Erfindung

Die EP 0 356 991 A2 zeigt eine Einheit mit einer Trägerplatte, auf deren erster Seite elektronische Bauelemente und auf deren zweiter Seite mehrere Kühlrippen zum Abführen von durch die elektronischen Bauelemente erzeugter Verlustwärme. Nur einige Kühlrippen, die in der Nähe zu einem elektronischen Bauelement liegen, sind entlang ihrer Längsachse in einer zur Trägerplatte parallelen Ebene gebogen, so dass vom Ventilator kommende Luft auf das elektronische Bauelement gelenkt werden.

Die DE 10 2007 057472 A1 zeigt einen Kühlkörper zum Abführen von Verlustwärme bestehend aus einer Vielzahl von Kühlrippen, im Wesentlichen vor einem Kühlventilator angeordnet, wobei zumindest einige der Rippen mit einer Schräge versehen sind.

Die JP H10 150284 A zeigt eine Einheit mit elektronischen Bauelementen umfassend einen aus Kühlrippen bestehenden Kühlkörper, der von einer Träger- und einer Abdeckplatte abgeschlossen ist, die einen Luftkanal zum Abführen von durch elektronische Bauelemente erzeugter Wärme bilden.

Vor diesem Hintergrund stellt sich die Erfindung die Aufgabe, bei gleichbleibendem Platzbedarf eine verbesserte Kühlung für elektronische Einheiten bereitzustellen. Dabei soll gleichzeitig ein verbesserter Schutz des Kühlsystems gegenüber Umwelteinflüssen gewährleistet werden.

Die Erfindung löst diese Aufgabe durch die Bereitstellung einer Einheit nach Anspruch 1. Die abhängigen Ansprüche betreffen vorteilhafte Ausführungsformen der Erfindung.

Eine erfindungsgemäße Einheit umfasst mehrere elektronische Bauelemente, die im Betrieb Verlustwärme erzeugen und an ihre Umgebung abgeben. Beispielsweise handelt es sich bei der Einheit um einen Frequenzumrichter oder eine andere Art von elektronischem Wandler. Jedoch ist die Erfindung auch auf beliebige andere elektronische Schaltungen anwendbar.

Des Weiteren weist die elektronische Einheit erfindungsgemäß eine Trägerplatte auf, auf der die elektronischen Bauelemente angeordnet sind. Auf einer ersten Seite der Trägerplatte ist erfindungsgemäß eine erste Gruppe der Bauelemente angeordnet, auf einer zweiten Seite der Trägerplatte eine zweite Gruppe der Bauelemente. Dabei umfasst die erste Gruppe in einer bevorzugten Ausführungsform solche Bauelemente, die empfindlich gegenüber äußeren Einflüssen sind und/oder die nicht ohne Weiteres mit einem eigenen Einzelgehäuse versehen bzw. räumlich von einer Schaltung entfernt werden können. Zu der zweiten Gruppe gehören häufig solche elektronischen Bauelemente, die einerseits eine große Menge an Verlustwärme erzeugen und andererseits eigenständig eine hohe Schutzart aufweisen. Beispielsweise kann eine hohe Schutzart erreicht werden, indem das jeweilige Bauelement in das Einzelgehäuse eingelegt und mit einer Vergussmasse vergossen wird, in die eine Dichtung mit eingegossen wurde. Als Bauelemente der zweiten Gruppe bieten sich beispielsweise Drosseln und andere gewickelte Bauteile an, die mit einem Einzelgehäuse ohne großen Aufwand ausreichend geschützt werden können.

Aus Schutzgründen umfasst die Einheit häufig ein Gehäuse, welches mit der Trägerplatte korrespondiert und die auf den beiden Seiten der Trägerplatte angeordneten Bauelemente aufnimmt. In einer Ausführungsform ist die Trägerplatte beispielsweise derart in einem Gehäuse angeordnet, dass sie das Gehäuse in zwei oder mehrere Teile teilt. Alternativ sind beide Seiten der Trägerplatte Teil eines eigenen Gehäuses. Je nach Anwendung weist das Gehäuse bzw. der Gehäuseteil, der die erste Gruppe von Bauelementen aufnimmt, in einigen Ausführungsbeispielen eine hohe Schutzart auf, um die Bauelemente in seinem Inneren u. a. vor Umwelteinflüssen, beispielsweise Feuchtigkeit und Schmutz, zu schützen. Hingegen besteht bei manchen Anwendungen keine oder nur wenig Notwendigkeit, die zweite Gruppe der Bauelemente durch ein (zusätzliches) Gehäuse vor Umwelteinflüssen zu schützen. So kann die zweite Seite der Trägerplatte in einer Ausführungsform zum Beispiel als Teil einer Gehäuseaußenwand ungeschützt bleiben, oder in einer anderen Ausführungsform in einem Gehäuse oder Gehäuseteil mit Lüftungsschlitzen liegen, die eine einfache Belüftung und Wärmeabfuhr ermöglichen. In einer anderen Ausführungsform sind auch die Bauelemente der zweiten Gruppe bzw. die zweite Seite der Trägerplatte durch ein Gehäuse bzw. ein Gehäuseteil hoher Schutzart geschützt.

Die beschriebene Aufteilung der Bauelemente auf zwei Seiten der Trägerplatte ermöglicht eine Auslagerung von elektronischen Bauelementen, die eine erhebliche Menge an Verlustwärme abgeben, aus einer (wärmeempfindlichen) Schaltung bzw. ggf. aus einem Gehäuse, das die erste Bauelementgruppe aufnimmt. Insbesondere ermöglicht diese Aufteilung das Auslagern solcher Bauelemente, die wenig Schutz vor Umwelteinflüssen benötigen oder einfach mit einem eigenen Gehäuse versehen werden können, und die daher ohne großen Aufwand aus einem größeren Gemeinschaftsgehäuse herausgezogen werden können. Andere Bauelemente, beispielsweise Leistungstransistoren, verbleiben vorzugsweise in der ersten Gruppe, obwohl sie relativ große Mengen an Verlustwärme abgeben, da das Versehen solcher Bauteile mit einem Einzelgehäuse zu aufwendig wäre. Auf Grund ihrer Auslagerung auf die andere Seite der Trägerplatte tragen die Bauelemente der zweiten Gruppe nicht mehr zu einer Erwärmung einer auf der ersten Seiten der Trägerplatte liegenden Schaltung mit der ersten Bauelementgruppe bei.

Zusätzlich zu den Bauelementen der zweiten Gruppe sind auf der zweiten Seite der Trägerplatte auch mehrere Kühlrippen angeordnet, die thermisch mit Bauelementen der ersten Gruppe gekoppelt sind, so dass die Kühlrippen von diesen Bauelementen erzeugte Wärme abführen können. Diese Kühlrippen sind erfindungsgemäß über ihre gesamte oder einen Teil ihrer Länge in einer zur Trägerplatte parallelen Ebene geschwungen ausgebildet. Das verwendete Material und im Folgenden nicht näher beschriebene Abmessungen der erfindungsgemäß vorgesehenen Kühlrippen entsprechen denjenigen konventioneller Kühlrippen.

Durch die geschwungene Form der Kühlrippen wird im Vergleich zu gerade ausgebildeten Kühlrippen auf demselben Raum eine effektivere Kühlung erzielt. Dies liegt insbesondere daran, dass durch die geschwungene Form entlang der Kühlrippen strömende Luft umgelenkt wird, so dass auftretende Grenzschichten aufgebrochen werden und sich Luftturbulenzen bilden, die ein besseres Überstreichen eines Luftstroms über die Kühlrippen sicherstellen. Außerdem vergrößert die geschwungene Form die Oberfläche der Kühlrippen, wodurch ein Wärmeaustausch auf einer größeren Fläche stattfinden kann. Diese Effekte verstärken sich noch, wenn eine Kühlrippe über ihre gesamte Länge geschwungen ausgebildet ist.

Ein weiterer Effekt der geschwungenen Kühlrippen besteht darin, dass diese Form für auf der zweiten Seite der Trägerplatte angeordnete Elemente einen Schutz vor Umwelteinflüssen bietet, beispielsweise vor Regenwasser. Dies gilt insbesondere für eine bevorzugte Ausführungsform der Erfindung, in der eine Ausrichtung eines zu schützenden Elements auf die Kühlrippen oder umgekehrt derart vorgenommen wird, dass die Kühlrippen, vom zu schützenden Element aus gesehen, in der Richtung angeordnet sind, aus der die Umwelteinflüsse hauptsächlich erfolgen. Weist die Einheit beispielsweise eine Aufhängevorrichtung auf, welche eine Seite der Einheit als "unten" und eine Seite der Einheit als "oben" definiert, ist das zu schützende Elemente vorteilhaft unter den Schwingungsbäuchen der Kühlrippen angeordnet. Zum Beispiel Regen tropft dann nicht auf das unter den Schwingungsbäuchen liegende Element, sondern sammelt sich an den Schwingungen und kann von dort definiert abgeleitet werden.

In einigen Ausführungsbeispielen weisen die Kühlrippen eine S-Form mit zwei oder mehreren etwa gleichgroßen Schwingungen in beide Richtungen um die Längsachse der jeweiligen Kühlrippe auf. Diese Art der Schwingung gewährleistet einen besonders guten Schutz vor Umwelteinflüssen wie Regenwasser, weil die Kühlrippen durch die beidseitige Schwingung besonders "breit" ausgestaltet sind und daher einen großen, unter den Schwingungsbäuchen liegenden Bereich abschirmen können. Durch die Regelmäßigkeit einer S-förmigen Schwingung ist die Ausrichtung auf ein zu schützendes Element zudem einfach zu bewerkstelligen.

Nach einer weiteren Ausführungsform sind eine oder beide der schmalen Seitenkanten der Kühlrippen abgeschrägt, so dass die Länge der Kühlrippen in der Nähe der Trägerplatte am größten ist und mit ihrer zunehmenden Höhe abnimmt. Vorzugsweise ist hierbei diejenige schmale Seitenkante abgeschrägt, die dem zu schützenden Element zugewendet ist bzw. näher bei diesem liegt. Die Abschrägung dient zu einer Verbesserung der Schutzwirkung insbesondere gegen Regenwasser: durch die Abschrägung wird das von den Schwingungen entlang der Kühlrippen abfließende Wasser definiert zu einem Punkt geleitet, anstatt über die gesamte Höhe der schmalen Seitenkante abzutropfen. Vorteilhaft wird die Abschrägung bzw. die Seitenkante der Kühlrippen so ausgestaltet bzw. das zu schützende Element so angeordnet, dass das Wasser an dem zu schützenden Element vorbei abfließt.

Häufig verlaufen die Kühlrippen parallel. Dies ist jedoch nicht immer der Fall. Beispielsweise können Abweichungen von der parallelen Ausrichtung aus anordnungstechnischen Gründen, zur Verstärkung der Turbulenzenbildung oder zur Umleitung von Kühlluft durch die Strömungswege hin zu bestimmten Stellen vorteilhaft sein. Vorzugsweise werden die Kühlrippen so aufeinander abgestimmt, dass die durch sie definierten Strömungswege Regenwasser oder andere Umwelteinflüsse möglichst gut abfangen und zum Beispiel kein Regenwasser auf geradem Weg durch die Strömungswege hindurchtropfen kann. Erreicht wird dies durch eine Anpassung der Größe und/oder Form der Schwingungen an den Abstand zwischen den Kühlrippen.

Bei dem zu schützenden Element handelt es sich vorzugsweise um einen Ventilator, der Kühlluft entlang der Kühlrippen leitet, um deren Kühlungswirkung zu verstärken. Beispielsweise ist der Ventilator an einem Ende der Trägerplatte angeordnet, das bei einer Aufhängung der Einheit unten liegt, und bläst Luft entlang von durch die Kühlrippen definierten Strömungswegen, die auf der Trägerplatte von unten nach oben verlaufen. Die Kühlrippen sind in dieser Ausführungsform so auf den Ventilator und vorzugsweise auch aufeinander ausgerichtet (oder umgekehrt), dass sie durch ihre geschwungene Form und ggf. durch ihre abgeschrägte ventilatorseitige Seitenkante von oben kommendes Wasser (beispielsweise Regenwasser) am Ventilator bzw. insbesondere am Ventilatormotor als dessen empfindlichstem Bestandteil vorbeileiten. Dadurch wird der Ventilator gegen Regenwasser und andere von oben wirkende Umwelteinflüsse, zum Beispiel Staub etc., zumindest teilweise geschützt.

In einer anderen Ausführungsform sind die Kühlrippen bzw. einige der Kühlrippen beispielsweise auf ein oder mehrere Bauelemente der zweiten Gruppe ausgerichtet und schützen diese auf die oben beschriebene Art und Weise.

Gemäß einer bevorzugten Ausführungsform sind die Bauelemente der zweiten Gruppe an den Rändern der Trägerplatte angeordnet. Dadurch stören diese Bauelemente einerseits nicht den Verlauf der Kühlrippen und können andererseits die von ihnen selbst abgegebene Wärme ungestört an die Umgebung abgeben, so dass sie die Kapazität der Kühlrippen zur Wärmeabfuhr von den Bauelementen der ersten Gruppe nicht beeinträchtigen.

### Kurze Beschreibung der Zeichnungen

Die folgenden Figuren erläutern die Erfindung an Hand von beispielhaften Ausführungsformen, wobei:
- Figur 1: schematisch eine Draufsicht auf eine Seite einer Trägerplatte einer erfindungsgemäßen Einheit zeigt; und
- Figur 2: eine explodierte Ansicht einer einseitig bestückten Trägerplatte einer erfindungsgemäßen Einheit zeigt.

### Detaillierte Beschreibung der Figuren

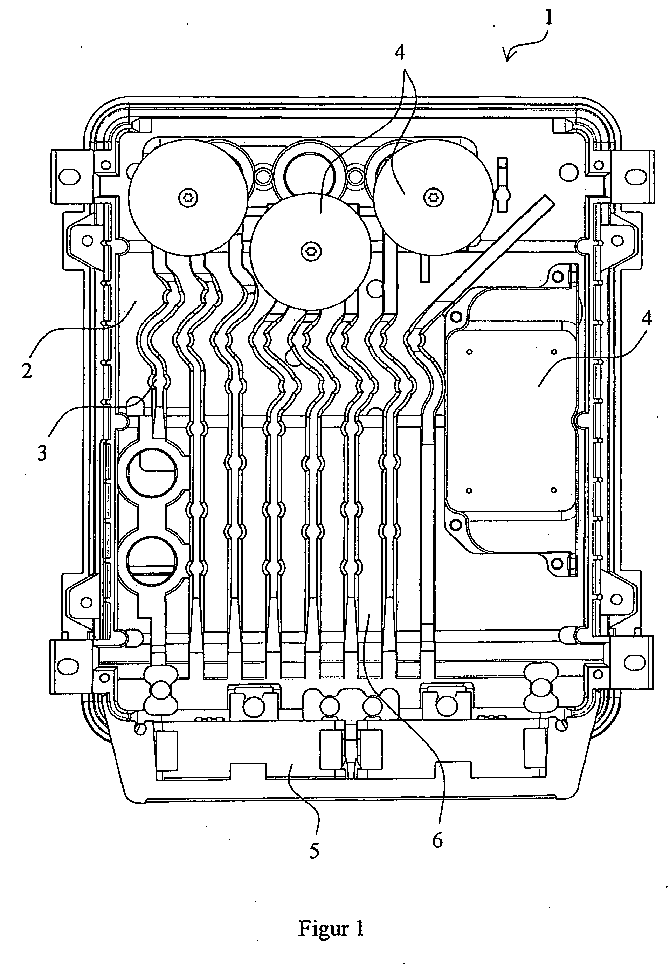

Figur 1 zeigt eine Draufsicht auf eine Trägerplatte 2 einer erfindungsgemäßen Einheit 1, hier ein Frequenzumrichter, mit Blick auf die zweite, Kühlrippen 3 umfassende Seite. Die erste Seite der Trägerplatte 2 mit den Bauelementen der ersten Gruppe ist in dieser Ansicht nicht zu sehen. Normalerweise ist die Trägerplatte 2 bei der gezeigten Ausführungsform durch ein Gehäuse geschützt, das für die Darstellung jedoch weggelassen wurde. Insbesondere teilt die Trägerplatte 2 bei der gezeigten Ausführungsform das Gehäuse in zwei Hälften, wobei die Gehäusehälfte, in der die zweite Seite der Trägerplatte 2 liegt, zum Beispiel rundum oder an der Ober- und Unterseite Luftöffnungen aufweist, die einen Wärmeaustausch mit der Umgebung gewährleisten. Die andere Gehäusehälfte, in der sich die erste Trägerplattenseite befindet, ist luftdicht ausgeführt und entspricht einer hohen Schutzart.

Die Einheit 1 besitzt eine nicht gezeigte Aufhängevorrichtung, welche eine Aufhängung der Einheit 1 mit der in der Figur dargestellten Ausrichtung zum Beispiel an einer Wand etc. ermöglicht. Als Oberseite der aufgehängten Einheit 1 definiert die Aufhängevorrichtung hier die Seite der Einheit 1, die sich auch in der Figur oben befindet.

Im oberen und rechten Bereich der Trägerplatte 2 sind in dieser Ausführungsform elektronische Bauelemente 4 der zweiten Bauelementgruppe angeordnet. Vorzugsweise sind diese Bauelemente 4 thermisch von der Trägerplatte 2 entkoppelt, beispielsweise indem durch eine Anordnung auf kleinen Pins ein gewisser Abstand zwischen den Bauelementen 4 und der Trägerplatte gewährleistet wird. Dies vermeidet eine Übertragung von Verlustwärme dieser Bauelemente auf die erste Seite der Trägerplatte 2.

Bei den gezeigten runden Bauelementen 4 handelt es sich um Sinusfilterdrosseln, die beim Frequenzumrichter zum Erzeugen einer sinusförmigen Ausgangsspannung verwendet werden, bei der im Wesentlichen rechteckigen Komponente um eine Zwischenkreisdrossel. Solche Drosseln geben im Betrieb erhebliche Wärmemengen ab. Daher verringert ihre Auslagerung von der ersten Seite der Trägerplatte 2 die aus der die erste Trägerplattenseite umschließenden, dichten Gehäusehälfte abzuführende Wärmemenge deutlich. Aus der zweiten Gehäusehälfte kann die zusätzliche Wärme auf Grund der Luftschlitze einfach abgeführt werden.

Bei der gezeigten Ausführungsform sind alle Bauelemente 4 der zweiten Gruppe in Einzelgehäusen mit einer zur Anwendung passenden Schutzart angeordnet. Konkret wird hierzu beispielsweise ein Bauelement in das Einzelgehäuse eingelegt und darin mit einem abdichtenden Vergussmaterial vergossen. Demnach schaden die durch die Luftschlitze wirkenden Umwelteinflüsse den Bauelementen nicht.

Im mittleren Bereich der Trägerplatte 2 erstrecken sich Kühlrippen 3, die für eine Abführung der Wärme von der ersten Seite der Trägerplatte 2 zuständig sind. Insbesondere befinden sich im gezeigten Beispiel Leistungsbauteile, beispielsweise ein IGBT (nicht gezeigt), auf der ersten Seite der Trägerplatte 2, deren Abwärme über die Trägerplatte 2 an die Kühlrippen 3 geleitet und von diesen an die Umgebung abgegeben wird. Für eine optimale Abführung der Wärme von den Kühlrippen 3 sind im unteren Bereich der Trägerplatte zwei Ventilatoren 5 angebracht, welche so auf die Kühlrippen 3 ausgerichtet sind, dass sie Luft entlang der Kühlrippen 3 von unten her durch Strömungswege 6 blasen können, welche die Kühlrippen 3 bilden. Diese Strömungswege 6 enden in der gezeigten Ausführungsform an den Sinusfilterdrosseln 4, so dass die Kühlluft auch diese Bauelemente überstreicht.

Die dargestellte Reservierung des großen mittleren Bereichs der Trägerplatte 2 für die Kühlrippen 3 wird durch die Anordnung der Bauelemente 4 in den Randbereichen der Trägerplatte 2 ermöglicht. Hierdurch ergibt sich ein weitgehend ungestörter Verlauf der Kühlrippen 3 bzw. eine geringe Einwirkung der Bauelemente 4 auf die Kühlungskapazität der Kühlrippen 3, so dass sich die Wärmemenge, die durch die Kühlrippen 3 abgeführt werden kann, noch weiter erhöht.

Wie in der Figur zu sehen, sind die Kühlrippen 3 in ihrem oberen Bereich um ihre jeweilige (in der Figur von unten nach oben verlaufende) Längsachse geschwungen augebildet. Diejenigen Kühlrippen 3, die über den am unteren Ende der Einheit 1 angeordneten Ventilatoren 5 bzw. deren (nicht gezeigten) Motoren liegen, weisen in der gezeigten Ausführungsform eine S-Form mit ungefähr gleichgroßen Schwingungen in beide Richtungen um eine Längsachse in einer zur Trägerplatte 2 parallelen Ebene auf. Im Gegensatz dazu sind die im linken Bereich der Figur liegenden Kühlrippen 3 nur in eine Richtung geschwungen. Dies liegt einerseits an dem begrenzten Raumangebot, andererseits am weniger stark benötigten Schutz von räumlich unter den Kühlrippen 3 liegenden Elementen in diesem Bereich. Auf Grund der unterschiedlichen Schwingung der einzelnen Kühlrippen 3 verlaufen diese nur teilweise parallel.

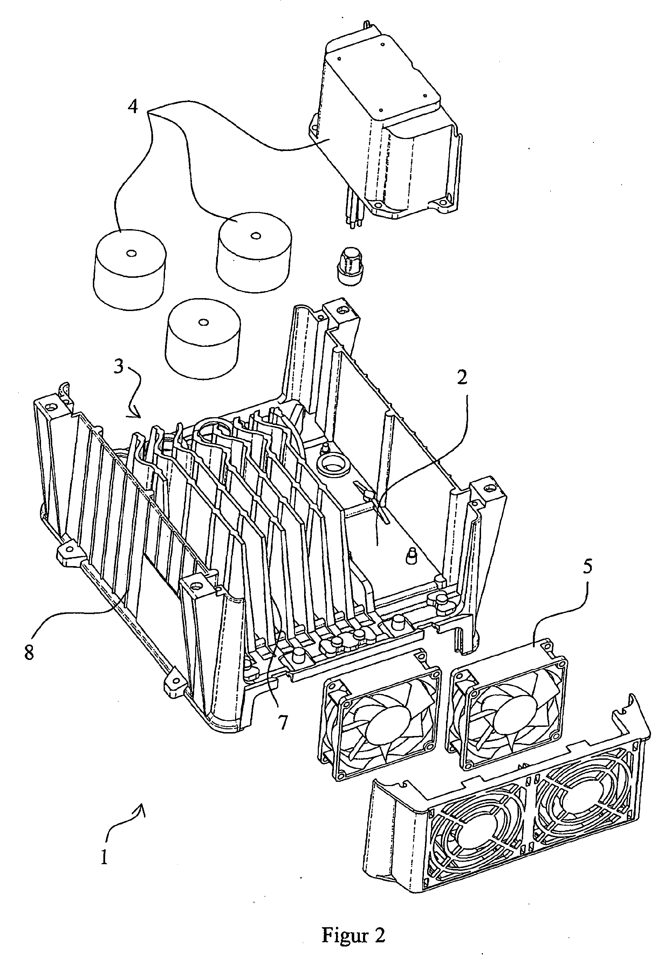

Um eine möglichst vollständige Abschirmung insbesondere gegen Regenwasser zu erreichen, sind in der gezeigten Ausführungsform die Abstände der Kühlrippen 3 und damit die Breite der Strömungswege 6 derart auf die Größe der Schwingungen abgestimmt, dass von oben kein Regenwasser direkt durch die Strömungswege auf die Ventilatoren 5 tropfen kann. Statt dessen tropft zum Beispiel in das Gehäuse eingedrungenes Regenwasser auf eine Schwingung einer Kühlrippe 3 und fließt weiter an der jeweiligen Kühlrippen 3 entlang, bis es über die abgeschrägte Seitenkante 7 (vgl. Figur 2) der Kühlrippen an einem definierten Punkt abgeleitet wird.

Durch die Schwingung der Kühlrippen 3 ergibt sich für die gezeigte Ausführungsform bei gleicher Baugröße eine gegenüber geraden Kühlrippen um 50% effektivere Kühlung. Dies liegt einerseits an der auf Grund der Schwingungen erreichten Umlenkung der Kühlluft, die zur Bildung von Turbulenzen führt, andererseits an der vergrößerten Fläche der Kühlrippen, die für einen Wärmeaustausch bereitsteht. Alternative Ausführungsformen umfassen Kühlrippen 3, die über ihre gesamte oder einen Großteil ihrer Länge geschwungen ausgebildet sind. Bei solchen Ausführungsformen verstärkt sich die Kühlungseffizienz weiter.

Figur 2 zeigt eine explodierte Darstellung eines anderen Ausführungsbeispiels einer erfindungsgemäßen Einheit 1, wobei die auf der ersten Seite der Trägerplatte 2 angeordneten Bauelemente der ersten Gruppe wiederum nicht gezeigt sind und Teile des Gehäuses 8 entfernt wurden. Für Elemente, die den in Figur 1 gezeigten Elementen entsprechen, wurden gleiche Bezugszeichen verwendet.

Abgesehen von den bereits in Bezug auf Figur 1 beschriebenen Eigenschaften der Kühlrippen 3 ist in dieser Darstellung auch der abgeschrägte Verlauf der ventilatorseitigen schmalen Seitenkante 7 der Kühlrippen deutlich zu erkennen, bei dem die Länge der Kühlrippen von der Trägerplatte 2 zum höchsten Punkt der Kühlrippen 3 hin abnimmt. Dieser abgeschrägte Verlauf ermöglicht eine Leitung von Regenwasser zu einem definierten Punkt an der Unterseite des Gehäuses 8. Vorzugsweise sind die Ventilatoren 5 so angeordnet, dass die Seitenkante 7 das Wasser an ihren Motoren vorbeileitet.

Des Weiteren sind in der Darstellung Teile eines Gehäuses 8 zu sehen. Normalerweise umschließt das Gehäuse 8 bei dieser Ausführungsform die Trägerplatte 2 mit den auf ihr angeordneten Elementen vollständig, wobei das Gehäuse 8 von der Trägerplatte 2 zweigeteilt wird. Der Gehäuseteil, in dem sich die erste Seite der Trägerplatte 2 befindet (in der Figur unten) weist eine hohe Schutzart auf und ist daher luft- und wasserdicht abgeschlossen. Der andere Gehäuseteil, in dem sich auch die Kühlrippen befinden (in der Figur oben), weist auf Grund der vorgesehenen Luftschlitze hingegen lediglich eine niedrige Schutzart auf.

Die Erfindung wurde hier in Bezug auf einen Frequenzumrichter beschrieben. Jedoch kommt die Erfindung auch für viele andere Anwendungen zum Einsatz, zum Beispiel bei beliebigen elektronischen Wandlern oder allen elektronischen Einheiten, bei denen eine Aufteilung von elektronischen Bauelementen in Gruppen vorteilhaft ist.

## Patentansprüche

1. Einheit (1) mit elektronischen Bauelementen (4), die im Betrieb Verlustwärme abgeben, umfassend:
eine Trägerplatte (2), auf deren erster Seite eine erste Gruppe der elektronischen Bauelemente (4) angeordnet ist, und auf deren zweiter Seite mehrere Kühlrippen (3) zum Abführen von durch elektronische Bauelemente der ersten Gruppe erzeugter Verlustwärme sowie eine zweite Gruppe der elektronischen Bauelemente (4) angeordnet sind,
ein Gehäuse bzw. ein Teil eines durch die Trägerplatte (2) in zwei Teile geteilten Gehäuses (8), das mit hoher Schutzart die erste Gruppe der Bauelemente (4) umschließt, und ein anderes Gehäuse bzw. ein anderer Teil des durch die Trägerplatte (2) in zwei Teile geteilten Gehäuses (8), das mit niedriger Schutzart die zweite Gruppe der Bauelemente (4) sowie die Kühlrippen (3) umschließt, und
eine Aufhängevorrichtung, welche für eine Aufhängung der Einheit (1) ausgelegt ist, bei der auftretende Umwelteinflüsse in Form von von oben kommendem Regenwasser oder Staub von oben nach unten entlang der Längsachse der Kühlrippen (3) wirken,
wobei die Kühlrippen (3) zumindest entlang eines Teils ihrer Längsachse in einer zur Trägerplatte (2) parallelen Ebene geschwungen ausgebildet sind, deren Abstände zueinander so auf deren geschwungene Form abgestimmt sind, dass das Regenwasser oder der Staub nicht auf geradem Weg durch die von den Kühlrippen (3) definierten Strömungswege (6) gelangen kann, wobei die Kühlrippen einen Schwingungsbauch aufweisen.

2. Einheit (1) nach Anspruch 1, umfassend einen Ventilator (5), der derart auf die Kühlrippen (3) ausgerichtet ist, dass er einerseits Luft in einer Strömungsrichtung entlang der Längsachse der Kühlrippen (3) bewegen kann und andererseits durch die geschwungene Form der Kühlrippen (3) zumindest teilweise vor dem Regenwasser geschützt wird.

3. Einheit (1) nach Anspruch 2, bei der sich der Ventilator (5) an der Seite der Einheit (1) befindet, die bei einer Aufhängung der Einheit (1) mittels der Aufhängevorrichtung unten liegt.

4. Einheit (1) nach einem der vorangehenden Ansprüche, bei der wenigstens ein elektronisches Bauelement (4) der zweiten Gruppe so angeordnet ist, dass es durch die geschwungene Form der Kühlrippen (3) zumindest teilweise vor dem Regenwasser geschützt wird.

5. Einheit (1) nach einem der vorangehenden Ansprüche, bei dem die Kühlrippen (3) an einer oder beiden ihrer schmalen Seitenkanten (7) abgeschrägt verlaufen, so dass die Länge der Kühlrippen (3) mit ihrer zunehmenden Höhe abnimmt.

6. Einheit (1) nach Anspruch 5 und einem der Ansprüche 2 bis 4, bei der die Kühlrippen (3) an der näher am zu schützenden Bauelement (4) bzw. Ventilator (5) liegenden schmalen Seitenkante (7) abgeschrägt sind.

7. Einheit (1) nach einem der vorangehenden Ansprüche, bei der die geschwungenen Kühlrippen (3) über einen Teil oder ihre gesamte Länge eine S-Form aufweisen.

8. Einheit (1) nach einem der vorangehenden Ansprüche, bei der die Trägerplatte (2) einen Teil der Außenseite des Gehäuses (8) bildet, wobei die zweite Seite der Trägerplatte außen liegt.

9. Einheit (1) nach einem der vorangehenden Ansprüche, bei der Bauelemente (4) der zweiten Gruppe jeweils ein abgedichtetes Einzelgehäuse aufweisen, das hergestellt wird, indem das Bauelement (4) in das Einzelgehäuse eingelegt wird und mit einer Vergussmasse vergossen wird, in die eine Dichtung mit eingegossen wurde.

10. Einheit (1) nach einem der vorangehenden Ansprüche, bei der die Bauelemente (4) der zweiten Gruppe in den Randbereichen der Trägerplatte (2) angeordnet sind.

## Claims

1. A unit (1) with electronic components (4), which emit heat loss during operation, comprising:
a carrier plate (2) wherein a first group of the electronic components (4) is arranged on its first side, and wherein multiple cooling ribs (3) for dissipation of heat loss, generated by the first group of the electronic components, and a second group of the electronic components (4) are arranged on its second side,
a housing or a portion of the housing (8) being divided into two parts by the carrier plate (2), which encloses the first group of the components (4) with high degree of protection, and a further housing or a further portion of the housing (8) being divided into two parts by the carrier plate (2), which encloses the second group of the components (4) and the cooling ribs (3) with low degree of protection, and
a suspension device, designed for a suspension of the unit (1), wherein occurring environmental influences in the form of rain water coming from above or dust act in a direction from top to bottom along the longitudinal axis of the cooling ribs (3),
wherein the cooling ribs (3) are curved formed at least along a part of their longitudinal axis in a plane parallel to the carrier plate (2), their distances between each other are adapted to their curved form, such that the rain water or the dust cannot get on a straight path through the flow paths (6) defined by the cooling ribs (3), wherein the cooling ribs have an antinode.

2. The unit (1) according to claim 1, comprising a fan (5), which is oriented to the cooling ribs (3) such that on the one hand it can move air in a flow direction along the longitudinal axis of the cooling ribs (3) and on the other hand it is at least partially protected against the rain water by the curved form of the cooling ribs (3).

3. The unit (1) according to claim 2, wherein the fan (5) is located on the side of the unit (1), which, when suspending the unit (1) by means of the suspension device, is located on the bottom.

4. The unit (1) according to any of the preceding claims, wherein at least one electronic component (4) of the second group is arranged such that it is protected at least partially against the rain water by the curved form of the cooling ribs (3).

5. The unit (1) according to any of the preceding claims, wherein the cooling ribs (3) on one or both of their narrow side edges (7) extend chamfered such that the length of the cooling ribs (3) decreases with its increasing height.

6. The unit (1) according to claim 5 and one of the claims 2 to 4, wherein the cooling ribs (3) on the narrow side edge (7) lying nearer to the component (4) or fan (5) to be protected, are chamfered.

7. The unit (1) according to any of the preceding claims, wherein the curved cooling ribs (3) have an S-shape along a portion or along their entire length.

8. The unit (1) according to any of the preceding claims, wherein the carrier plate (2) forms a portion of the external side of the housing (8), wherein the second side of the carrier plate is located external.

9. The unit (1) according to any of the preceding claims, wherein components (4) of the second group respectively have a sealed single housing, manufactured by inserting the component (4) into the single housing and by casting it with a casting compound in which a seal was molded.

10. The unit (1) according to any of the preceding claims, wherein the components (4) of the second group are arranged in the edge regions of the carrier plate (2).

## Revendications

1. Unité (1) comprenant des composants (4) électroniques, qui dissipent en fonctionnement la chaleur perdue, comprenant :
une plaque de support (2), sur la première face de laquelle un premier groupe des composants (4) électroniques est disposé et sur la seconde face de laquelle plusieurs nervures de refroidissement (3) servant à évacuer la chaleur perdue générée par des composants électroniques du premier groupe ainsi qu'un deuxième groupe des composants (4) électroniques sont disposés,
un boîtier ou une partie d'un boîtier (8) divisé en deux parties par la plaque de support (2), lequel boîtier renferme le premier groupe des composants (4) avec un degré de protection élevé,
et un autre boîtier ou une autre partie du boîtier (8) divisé en deux parties par la plaque de support (2), lequel boîtier renferme le deuxième groupe des composants (4) ainsi que les nervures de refroidissement (3) avec un degré de protection inférieur, et
un dispositif d'accrochage, qui est configuré pour un accrochage de l'unité (1), lors duquel l'apparition de facteurs environnementaux sous la forme de pluie ou de poussières arrivant du haut agit du haut vers le bas le long de l'axe longitudinal des nervures de refroidissement (3),
dans laquelle les nervures de refroidissement (3) sont réalisées de manière ondulée au moins le long d'une partie de leur axe longitudinal dans un plan parallèle par rapport à la plaque de support (2), les distances entre lesdites nervures de refroidissement les unes par rapport aux autres sont adaptées à leur forme ondulée de sorte que l'eau de pluie ou la poussière ne puisse pas atteindre et traverser, sur un trajet rectiligne, les trajets d'écoulement (6) définis par les nervures de refroidissement (3), dans laquelle les nervures de refroidissement présentent un ventre ondulé.

2. Unité (1) selon la revendication 1, comprenant un ventilateur (5), qui est orienté de telle manière sur les nervures de refroidissement (3), qu'il peut déplacer d'une part l'air dans une direction d'écoulement le long de l'axe longitudinal des nervures de refroidissement (3) et qu'il est protégé d'autre part au moins en partie de l'eau de pluie par la forme ondulée des nervures de refroidissement (3).

3. Unité (1) selon la revendication 2, dans laquelle le ventilateur (5) se trouve au niveau de la face de l'unité (1), qui se trouve en bas lorsque l'unité (1) est accrochée au moyen du dispositif d'accrochage.

4. Unité (1) selon l'une quelconque des revendications précédentes, dans laquelle au moins un composant (4) électronique du deuxième groupe est disposé de telle sorte qu'il est protégé au moins en partie de l'eau de pluie par la forme ondulée des nervures de refroidissement (3).

5. Unité (1) selon l'une quelconque des revendications précédentes, les nervures de refroidissement (3) s'étendant en biseau au niveau d'une ou de deux de leurs arêtes latérales (7) étroites si bien que la longueur des nervures de refroidissement (3) diminue au fur et à mesure que leur hauteur augmente.

6. Unité (1) selon la revendication 5 et selon l'une quelconque des revendications 2 à 4, dans laquelle les nervures de refroidissement (3) sont biseautées au niveau de l'arête latérale (7) étroite se trouvant davantage à proximité au niveau du composant (4) à protéger ou au niveau du ventilateur (5).

7. Unité (1) selon l'une quelconque des revendications précédentes, dans laquelle les nervures de refroidissement (3) ondulées présentent une forme en S sur une partie ou sur l'ensemble de leur longueur.

8. Unité (1) selon l'une quelconque des revendications précédentes, dans laquelle la plaque de support (2) forme une partie du côté extérieur du boîtier (8), dans laquelle la seconde face de la plaque de support est située côté extérieur.

9. Unité (1) selon l'une quelconque des revendications précédentes, dans laquelle des composants (4) du deuxième groupe présentent respectivement un boîtier individuel étanchéifié, qui est fabriqué en ce que le composant (4) est placé dans le boîtier individuel et est scellé à l'aide d'une masse de scellement, dans laquelle un joint d'étanchéité a été intégré au coulage.

10. Unité (1) selon l'une quelconque des revendications précédentes, dans laquelle les composants (4) du deuxième groupe sont disposés dans les zones de bordure de la plaque de support (2).
